# EUROPÄISCHE PATENTSCHRIFT

(11) **EP 1 232 528 B1**
(45) Veröffentlichungstag und Bekanntmachung des Hinweises auf die Patenterteilung: **26.12.2007**
(21) Anmeldenummer: 00966118.2
(22) Anmeldetag: 05.10.2000
(51) Int. Cl.: H01L 27/108

(54) **DRAM MIT BITLEITUNGEN IN ZWEI METALLISIERUNGSEBENEN**
DRAM WITH BITLINES IN TWO METALLISATION LEVELS
DRAM AVEC LIGNES DE BIT A DEUX NIVEAUX DE METALLISATION

(30) Priorität: 08.10.1999 DE 19948571
(43) Veröffentlichungstag der Anmeldung: 21.08.2002
(73) Patentinhaber: Qimonda AG, 81739 München (DE)
(72) Erfinder: HÖNIGSCHMID, Heinz, 82319 Starnberg (DE); BRAUN, Georg, 80339 München (DE)
(74) Vertreter: Zimmermann & Partner
(86) Internationale Anmeldenummer: PCT/EP2000/009739
(87) Internationale Veröffentlichungsnummer: WO 2001/027974

(56) Entgegenhaltungen:
- EP-A- 0 452 648
- US-A- 5 715 189
- US-A- 5 815 428
- US-A- 5 821 592
- US-A- 6 124 199
- PATENT ABSTRACTS OF JAPAN vol. 1997, no. 07, 31. Juli 1997 (1997-07-31) & JP 09 082904 A (TOSHIBA CORP), 28. März 1997 (1997-03-28)
- PATENT ABSTRACTS OF JAPAN vol. 1997, no. 03, 31. März 1997 (1997-03-31) & JP 08 288471 A (TOSHIBA CORP), 1. November 1996 (1996-11-01)

## Beschreibung

Die vorliegende Erfindung betrifft eine Speicheranordnung. Die vorliegende Erfindung betrifft insbesondere eine dynamische Speicheranordnung mit einem Speicherzellenfeld aus einer Vielzahl von Speicherzellen, die jeweils wenigstens einen Auswahltransistor und einen Speicherkondensator aufweisen und über Wort- und Bitleitungen ansteuerbar sind.

Eine dynamische Speicheranordnung umfaßt typischerweise eine Vielzahl von Speicherzellen. Jede Speicherzelle enthält dabei wenigstens einen Auswahltransistor und einen Speicherkondensator. Diese Speicherzellen sind in der Regel in Reihen und Spalten angeordnet, wobei eine Vielzahl von Bitleitungen und Wortleitungen verwendet wird, um gezielt einzelne Speicherzellen anzusprechen zu können. Bei herkömmlichen Speicheranordnungen kann durch die Auswahl einer Bitleitung und durch die Auswahl einer Wortleitung eine Speicherzelle zum Lesen bzw. Schreiben ausgewählt werden. Dabei steuert die Wortleitungen den Auswahltransistor, so daß der Auswahltransistor den Speicherkondensator mit der Bitleitung elektrisch leitend verbindet. Auf diese Weise kann über die Bitleitung Ladung in dem Speicherkondensator gespeichert bzw. aus dem Speicherkondensator ausgelesen werden.

Speicheranordnungen sind bereits aus US-A-5 815 428, US-A-5 715 189, US-A-5 821 592 und JP-A-09 08 2904 bekannt.

Zum Auslesen der in einem Speicherkondensator gespeicherten Ladung werden üblicherweise Verstärker verwendet. Die Verstärker sind dabei in der Regel an den Enden der Bitleitungen angeordnet. Da beim Auslesen eines ausgewählten Speicherkondensators nur sehr kleine Ströme fließen, sind die Verstärker üblicherweise jeweils mit einem Paar von Bitleitungen verbunden. Eine der Bitleitungen dient dann als eine Referenzleitung für die andere Bitleitung, so daß der Verstärker aus den Unterschieden zwischen den beiden Bitleitungen auf die im ausgewählten Speicherkondensator gespeicherte Ladung schließen kann. Üblicherweise wird dann eine der Bitleitungen auf eine hohes Potential und die andere Bitleitung auf ein niedriges Potential gesetzt. Man spricht daher von komplementären Bitleitungen. Die Bitleitungen werden in der Regel in einer Metallisierungsebene geführt, wobei durch Kontaktlöcher die Verbindung zu den Diffusionsgebieten der Auswahltransistoren hergestellt wird.

Ein großer Teil des Aufwands bei der Technologieentwicklung von dynamischen Speicheranordnung liegt in der Erzeugung des Speicherkondensators. Um beim Auslesen des Speicherkondensators ein ausreichend großes Signal zu bekommen, sollte die Speicherkapazität des Speicherkondensators mindestens 35 fF betragen. Da gleichzeitig die laterale Ausdehnung des Speicherkondensators immer kleiner wird, ist man gezwungen, immer komplexere 3-dimensionale Strukturen zu erzeugen, um genügend Kondensatorfläche zur Verfügung stellen zu können.

Eine häufig genutzte Ausführungsform sind dabei die sogenannten Stapelkondensatoren (Stacked Capacitor). Stapelkondensatoren gibt es in einer Reihe unterschiedlicher Ausprägungen, beispielsweise Kronen-Stapelkondensatoren (Crown Stacked Capacitors) oder Rauh-Silizium-Stapelkondensatoren (Hemi-Spherical Grained Stacked Capacitors). All diesen Ausprägungen ist jedoch gemein, daß sie oberhalb des Siliziumsubstrats und oberhalb der Auswahltransistoren angeordnet sind. Damit liegen sie in einem Bereich der Speicheranordnung, in dem auch die Bitleitungen angeordnet werden. Insbesondere, wenn Paare von Bitleitungen verwendet werden, stellt sich somit die Aufgabe, die Bitleitungen und die Speicherkondensatoren so anzuordnen, daß pro Speicherzelle eine möglichst geringe Fläche verbraucht wird und gleichzeitig eine kostengünstige Produktion der Speicherzelle möglich ist.

Diese Aufgabe wird erfindungsgemäß von der Speicheranordnung nach dem unabhängigen Patentanspruch 1 gelöst. Weitere vorteilhafte Ausführungsformen, Eigenschaften und Aspekte der vorliegenden Erfindung ergeben sich aus den abhängigen Ansprüchen, der Beschreibung und den beiliegenden Zeichnungen.

Erfindungsgemäß wird eine Speicheranordnung mit einer Vielzahl von Speicherzellen bereitgestellt, die jeweils wenigstens einen Auswahltransistor und einen Stapelkondensator aufweisen und über Wort- und Bitleitungen ansteuerbar sind. Die erfindungsgemäße Speicheranordnung ist dadurch gekennzeichnet, daß
a) eine erste leitfähige Schicht (14),
b) eine zweite leitfähige Schicht (16), die von der ersten leitfähigen Schicht (14) durch isolierende Schicht (12) getrennt ist, und
c) jeweils für eine vorbestimmte Anzahl der Speicherzellen eine erste Bitleitung (BL<0>, BL<1>, BL<2>) und eine zweite Bitleitung (bBL<0>, bBL<1>, bBL<2>) vorgesehen sind, welche jeweils zum Teil in der ersten leitfähigen Schicht (14) geführt und von dort mit zumindest einem Teil der Speicherzellen verbunden sind und die jeweils zum Teil in der zweiten leitfähigen Schicht (16) geführt sind, und wobei der Teil der ersten Bitleitung (BL<0>, BL<1>, BL<2>) bzw. der zweite Bitleitung (bBL<0>, bBL<1>, bBL<2>), der in der ersten leitfähigen Schicht (14) geführt ist, und der Teil der ersten Bitleitung (BL<0>, BL<1>, BL<2>) bzw. der zweite Bitleitung (bBL<0>, bBL<1>, bBL<2>), der in der zweiten leitfähigen Schicht (16) geführt ist, über zumindest einen ersten Kontakt (17B) bzw. zumindest einen zweiten Kontakt (17A) durch die isolierende Schicht (12) miteinander verbunden sind,
d) beim Auslesen der Speicherzellen die ersten Bitleitungen (BL<0>, BL<1>, BL<2>) und die zweiten Bitleitung (bBL<0>, bBL<1>, bBL<2>) zueinander komplementär sind,
e) die Stapelkondensatoren (7,8,9) der Speicherzellen zwischen der ersten und der zweiten leitfähigen Schicht angeordnet sind, und
f) der erste und/oder zweite Kontakt (17A, 17B) über aktiven Gebiet überlappend mit einem Kontaktloch (15) zu einer Speicherzelle angeordnet sind.

Die erfindungsgemäße Speicheranordnung besitzt den Vorteil, daß durch die Anordnung Stapelkondensatoren zwischen der ersten und der zweiten leitfähigen Schicht sowohl die Aspektverhältnisse der Kontaktlöcher, welche die ersten leitfähige Schicht mit den Auswahltransistoren verbindet, als auch die Aspektverhältnisse der sogenannten "Plugs", welche die Speicherkondensatoren mit den Auswahltransistoren verbindet, relativ niedrig gehalten werden können. Weiterhin können durch die Verwendung von zwei leitfähigen Schichten, beispielsweise zwei Metallisierungsebenen, Bitleitungskonzepte realisiert werden, die selbst bei einem starken Rauschen auf den Bitleitungen ein sicheres Auslesen der in dem Stapelkondensator gespeicherten Ladung ermöglichen. Darüber hinaus können durch die erfindungsgemäße Speicheranordnung Speicherzellen realisiert werden, deren laterale Ausdehnung kleiner oder gleich 7F² ist. Dabei steht F (Feature size) für die kleinste von der verwendeten Herstellungstechnologie erzeugbare Strukturbreite.

Es ist für die vorbestimmte Anzahl der Speicherzellen eine zweite Bitleitung vorgesehen, die zum Teil in der ersten leitfähigen Schicht und von dort mit zumindest einem Teil der Speicherzellen verbunden ist und die zum Teil in der zweiten leitfähigen Schicht geführt ist. Dabei ist es insbesondere bevorzugt, wenn beim Auslesen der Speicherzellen die Bitleitungen zueinander komplementär sind.

Es ist bevorzugt, wenn die Bitleitungen mit einem Verstärker verbunden sind, der die Ladung ausließt, die in einer der Speicherzellen gespeichert ist.

Es sind der Teil der ersten Bitleitung, der in der ersten leitfähigen Schicht geführt ist, und der Teil der ersten Bitleitung, der in der zweiten leitfähigen Schicht geführt ist, über zumindest einen ersten Kontakt durch die isolierende Schicht miteinander verbunden.

Es sind, wenn der Teil der zweiten Bitleitung, der in der ersten leitfähigen Schicht geführt ist, und der Teil der zweiten Bitleitung, der in der zweiten leitfähigen Schicht geführt ist, über zumindest einen zweiten Kontakt durch die isolierende Schicht miteinander verbunden. Dabei ist es insbesondere bevorzugt, wenn der erste und zweite Kontakt so angeordnet sind, daß für den Verstärker die Kapazitäten der ersten und der zweiten Bitleitung im wesentlichen gleich sind.

Es sind der erste und/oder zweite Kontakt über aktiven Gebiet angeordnet. Dies hat den Vorteil, daß für diese Kontaktbereiche keine zusätzliche Chipfläche zur Verfügung gestellt werden muß. Dementsprechend erhöht die erzielbare Speicherdichte.

Dabei sind der erste und/oder zweite Kontakt überlappend mit einem Kontaktloch zu einer Speicherzelle angeordnet. Weiterhin ist es bevorzugt, wenn zwischen dem ersten und/oder zweiten Kontakt und der ersten leitenden Schicht ein Landing Pad angeordnet ist und/oder wenn im Bereich des ersten und/oder zweiten Kontakts die ersten leitende Schicht eine Verbreiterung aufweist.

Gemäß einer weiteren bevorzugten Ausführungsform sind die Speicherzellen mit einem Winkel zwischen 10° und 60°, insbesondere mit einem Winkel zwischen 20° und 40°, gegenüber der ersten und/oder der zweiten Bitleitung ausgerichtet.

Weiterhin ist es bevorzugt, wenn die Speicherzellen mit einer lateralen Ausdehnung von kleiner oder gleich 7F² ausgebildet sind.

Nachfolgend wird die Erfindung anhand der Zeichnungen näher erläutert. Es zeigen:
- Fig. 1: ein Speicheranordnung nach einem ersten Ausführungsbeispiel,
- Fig. 2: eine schematische Aufsicht auf eine Speicheranordnung,
- Fig. 3: einen schematischen Verlauf der Bitleitungen entlang einer Reihe von Speicherzellen,
- Fig. 4: einen schematischen Verlauf der Bitleitungen entlang einer Reihe von Speicherzellen gemäß einer Ausführungsform der vorliegenden Erfindung,
- Fig. 5: eine schematische Aufsicht auf die erfindungsgemäße Speicheranordnung gemäß Fig. 4,
- Fig. 6: einen Schnitt durch die erfindungsgemäße Speicheranordnung gemäß Fig. 4.
- Fig. 7: eine zu der in Fig. 6 gezeigten Ausführungsform abgewandelte Ausführungsform der vorliegenden Erfindung.

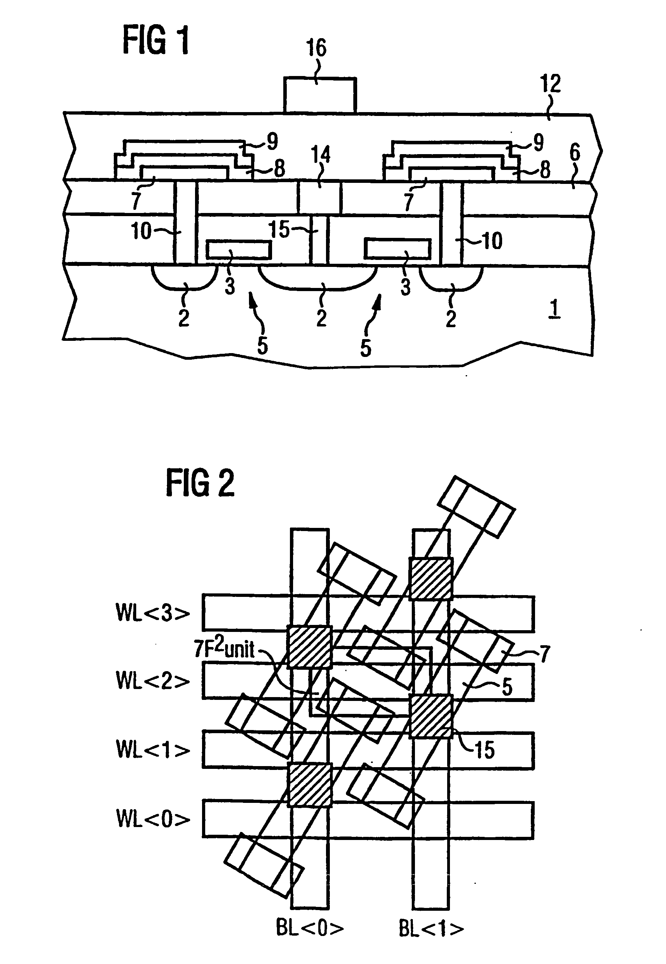

Fig. 1 zeigt eine Speicheranordnung. Ein Halbleitersubstrat 1, üblicherweise Silizium, mit darin angeordneten Diffusionsgebieten 2 wird bereitgestellt. Die Diffusionsgebiete 2 bilden zusammen mit den Gateelektroden 3 die Auswahltransistoren 5. Dabei verwenden, in diesem Beispiel, die Auswahltransistoren 5 zweier Speicherzellen jeweils ein Diffusionsgebiet 2 gemeinsam, um den Platzbedarf einer Speicherzelle möglichst klein zu halten. Eine Vielzahl von Gateelektroden 3 sind in der Richtung senkrecht zur Zeichenebene über Wortleitungen elektrisch leitend miteinander verbunden. Um die verschiedenen Wortleitungen bzw. Gateelektroden 3 von einander elektrisch zu isolieren, sind die Wortleitungen (Gateelektroden 3) von isolierendem Material 4, beispielsweise Siliziumdioxid, umgeben.

Um leitenden Verbindung zwischen den Diffusionsgebieten 2 der Speicherzellen und den Bitleitungen herstellen zu können, sind in dem isolierenden Material 4 Kontaktlöcher 15 vorgesehen, die mit einem leitfähigen Material, beispielsweise dotierten Silizium oder Wolfram, gefüllt sind. Zur Erzeugung eines Teils der Bitleitungen wird anschließend auf dem isolierenden Material 4 eine erste leitfähige Schicht 14, beispielsweise eine Aluminiumschicht, erzeugt. Diese erste leitfähige Schicht 14 wird nachfolgend strukturiert, so daß die Bitleitungen gebildet werden. Dabei sind die Bitleitungen so angeordnet, daß sie über Kontaktlöcher 15 mit den Diffusionsgebieten 2 der Auswahltransistoren 5 in Verbindung stehen. Zur Isolation der verschiedenen Bitleitungen ist wiederum eine isolierende Schicht vorgesehen, die in der Figur 1 mit dem Bezugszeichen 6 bezeichnet ist.

Auf dem isolierenden Material 6 sind die Stapelkondensatoren angeordnet, die sich aus einer ersten Elektrode 7, einem nicht leitenden, dielektrischen oder ferroelektrischen Material 8 und einer zweiten Elektrode 9 zusammensetzen. Die Auswahltransistoren 5 einer jeden Speicherzelle sind jeweils über einen sogenannten "Plug" 10 elektrisch leitend mit der ersten Elektrode 7 des Stapelkondensators verbunden. Der Plug 10 ist dabei üblicherweise aus dotiertem Polysilizium-gebildet. Auf die obere Elektrode 9 wird nun eine isolierende Schicht 12 aufgebracht. Als isolierende Schicht kann beispielsweise eine SiO₂-Schicht verwendet werden, die mit einem CVD-Verfahren abgeschieden wird.

Zur Erzeugung des weiteren Teils der Bitleitungen wird anschließend auf dem isolierenden Material 12 eine zweite leitfähige Schicht 16, beispielsweise wiederum eine Aluminiumschicht, erzeugt. Diese zweite leitfähige Schicht 16 wird nachfolgend strukturiert, so daß wiederum Bitleitungen gebildet werden.

Fig. 2 zeigt eine schematische Aufsicht auf eine Speicheranordnung. Fig. 2 zeigt acht Speicherzellen, wobei von den Stapelkondensatoren nur die untere Elektrode 7 gezeigt ist. Die Speicherzellen sind über die Kontaktlöcher 15 mit den Bitleitungen BL<0> und BL<1> verbunden. Die Bitleitungen BL<0> und BL<1> verlaufen in Fig. 2 von oben nach unten. Von den Bitleitungen BL<0> und BL<1> ist in Fig. 2 nur der Teil gezeigt, der in der ersten leitfähigen Schicht 14 unterhalb der unteren Elektrode 7 der Stapelkondensatoren verläuft. Direkt oberhalb der Bitleitungen BL<0> und BL<1> (oberhalb der Zeichenebene, nicht gezeigt) verläuft jeweils die zur der gezeigten Bitleitung BL<0> oder BL<1> komplementäre Bitleitung.

Senkrecht zu den Bitleitungen BL<0> und BL<1> verlaufen die Wortleitungen WL<0> bis WL<4>, welche die Auswahltransistoren der Speicherzellen steuern. Wie aus Fig. 2 ersichtlich sind die Speicherzellen mit einem Winkel von etwa 30° gegenüber den Bitleitungen BL<0> und BL<1> ausgerichtet. Durch diese Ausrichtung der Speicherzellen lassen sich die Speicherzellen dichter anordnen, wodurch sich bei gegebener Chipfläche die Speicherkapazität steigern läßt. Das schraffierte Gebiet in der Mitte der Fig. 2 zeigt die Ausdehnung der auf diese Weise erzeugten 7F²-Einheit.

Würden nun nur die Bitleitungen BL<0> und BL<1> in der ersten leitfähigen Schicht 14 geführt, während die zu ihnen komplementären Bitleitungen in der darüberliegenden leitfähigen Schicht 16 geführt werden, hätte dies zur Folge, daß die Kapazitäten und die Widerstände der Bitleitungen BL<0> und BL<1> und ihren komplementären Bitleitungen deutlich unterschiedlich wären. Dies hätte wiederum zur Folge, daß die Messung der Verstärker negativ beeinflußt werden würde.

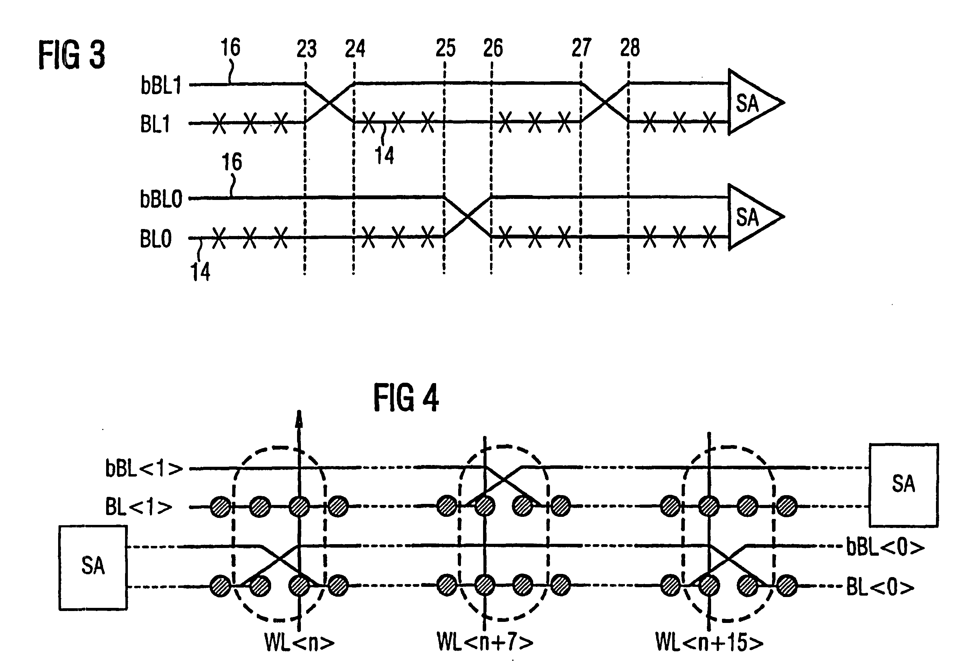

Um dies zu vermeiden, werden die Bitleitungen BL<0> und BL<1> und die entsprechenden komplementären Bitleitungen bBL<0> und bBL<1> sowohl in der unteren als auch in der oberen leitfähigen Schicht geführt. Dies soll am Beispiel der Fig. 3 näher erläutert werden. Die Bitleitung BL<1> wird in der unteren leitenden Schicht von der linken Seite der Zeichnung bis zu der Linie 23 geführt. Zwischen der Linie 23 und der Linie 24 wird ein Kontakt bereitgestellt, um die Bitleitungen BL<1> mit der oberen leitenden Schicht zu verbinden. Von der Linie 24 zu der Linie 27 wird die Bitleitungen BL<1> in der oberen leitenden Schicht (Metallisierungsebene) geführt.

Die komplementäre Bitleitung bBL<1> wird in der oberen leitenden Schicht (Metallisierungsebene) von der linken Seite der Zeichnung bis zu der Linie 23 geführt. Zwischen der Linie 23 und der Linie 24 wird ein weiterer Kontakt bereitgestellt, der die Bitleitung bBL<1> mit der unteren leitenden Schicht (Metallisierungsebene) verbindet. Zwischen der Linie 24 und der Linie 27 wird die Bitleitung bBL<1> in der unteren leitenden Schicht (Metallisierungsebene) geführt. Dabei ist jeweils die Bitleitung BL<1> oder bBL<1> mit den Speicherzellen verbunden, die in der unteren leitenden Schicht (Metallisierungsebene) geführt ist. Auf diese Weise ist es gewährleistet, daß die Kapazitäten und die Widerstände der beiden Bitleitungen BL<1> und bBL<1> im wesentlichen gleich groß ist.

In ähnlicher Weise verhalten sich die Bitleitungen BL<0> und bBL<0>, die im unteren Teil der Fig. 3 gezeigt sind. Hier erfolgt der Übergang der beiden Bitleitungen BL<0> und bBL<0> zwischen Linien 25 und 26. Am rechten Ende der Bitleitungen BL<1> und bBL<1> sowie BL<0> und bBL<0> sind jeweils Verstärker SA (sense amplifier) angeordnet, die die aus den Speicherzellen ausgelesene Ladung registrieren. Wie aus Fig. 3 ersichtlich sind für die Kontakte zwischen der oberen und der unteren leitenden Schicht eigene Zonen zwischen den Linien 24 und 25, 26 und 27 sowie 27 und 28 vorgesehen. In diesen Zonen sind keine Speicherzellen vorgesehen.

Zur weiteren Erhöhung der Speicherdichte zeigt Fig. 4 eine Ausführungsform der vorliegenden Erfindung. Wiederum werden die Bitleitungen BL<0> und BL<1> und die entsprechenden komplementären Bitleitungen bBL<0> und bBL<1> sowohl in der unteren als auch in der oberen leitfähigen Schicht geführt. Im Gegensatz zu der in Fig. 3 gezeigten Ausführungsform werden jedoch nun die Kontakte, welche die obere und die untere leitende Schicht miteinander verbinden, direkt über aktiven Gebieten, d.h. im der Bereich der Speicherzellen, bereitgestellt. Dementsprechend können Zonen, an denen nur Kontakte zwischen der oberen und unteren leitenden Schicht vorgesehen sind (siehe Fig. 3), vermieden werden.

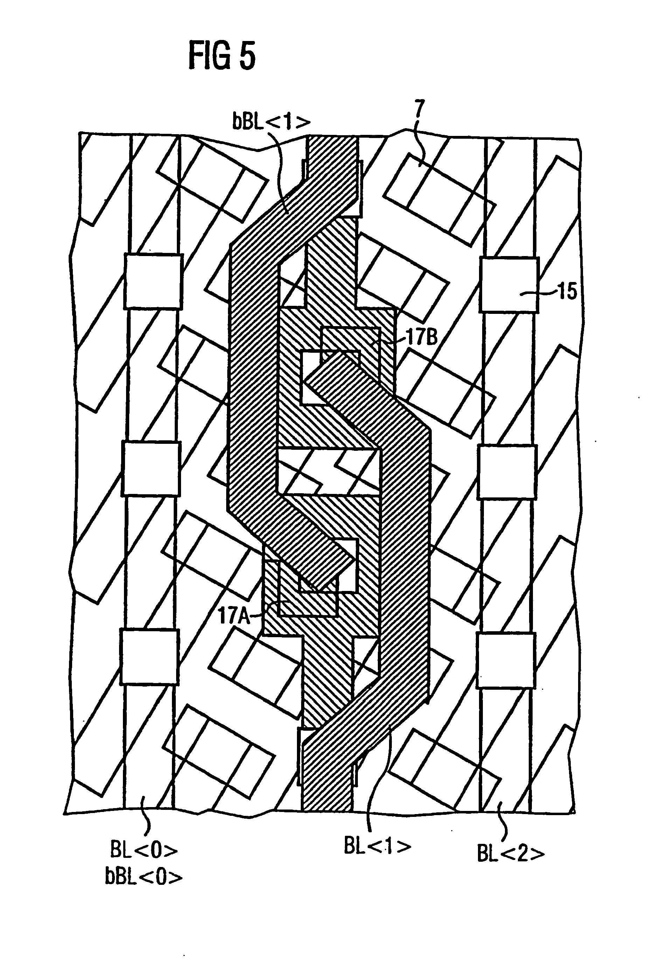

Fig. 5 zeigt eine schematische Aufsicht auf die erfindungsgemäße Speicheranordnung gemäß Fig. 4. Fig. 5 zeigt wiederum eine Reihe von Speicherzellen, wobei von den Stapelkondensatoren nur die untere Elektrode 7 gezeigt ist. Die Speicherzellen sind über die Kontaktlöcher 15 mit den Bitleitungen BL<0>, BL<1> und BL<2> verbunden. Die Bitleitungen BL<0>, BL<1> und BL<2> verlaufen in Fig. 5 von oben nach unten. Im Gegensatz zu Fig. 2 sind in Figur 5 auch die zur den Bitleitung BL<0>, BL<1> und BL<2> komplementäre Bitleitungen bBL<0>, bBL<1> und bBL<2> gezeigt.

Wortleitungen, welche die Auswahltransistoren der Speicherzellen steuern, sind in Fig. 5 aus Gründen der Übersichtlichkeit nicht gezeigt. Wie aus Fig. 5 ersichtlich sind die Speicherzellen wiederum mit einem Winkel von etwa 30° gegenüber den Bitleitungen BL<0>, BL<1> und BL<2> ausgerichtet. Durch diese Ausrichtung der Speicherzellen lassen sich die Speicherzellen dichter anordnen, wodurch sich bei gegebener Chipfläche die Speicherkapazität steigern läßt.

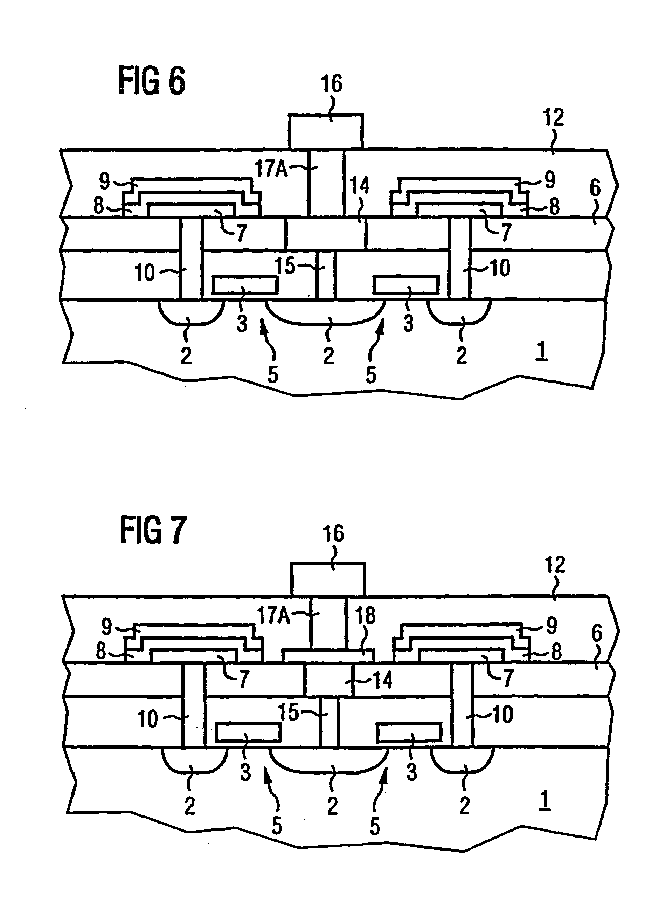

Der in Fig. 5 sichtbare Ausschnitt der Bitleitungen BL<0>, BL<1> und BL<2> bzw. der komplementäre Bitleitungen bBL<0>, bBL<1> und bBL<2> ist so gewählt, daß für Bitleitungen BL<1> und bBL<1> zwei Kontakte 17A und 17B (siehe auch Fig. 6) vorgesehen sind, damit die Bitleitungen BL<1> und bBL<1> zwischen der oberen und der unteren leitfähigen Schicht wechseln können. Am unteren Rand der Fig. 5 wird die Bitleitung BL<1> in der oberen leitenden Schicht geführt. In der oberen leitenden Schicht wird die Bitleitung BL<1> auf der rechten Seite an dem Kontakt 17A vorbei geführt und trifft dann auf den Kontakt 17B. Durch den Kontakt 17B wird die Bitleitung BL<1> zu der unteren leitenden Schicht geführt, welche an dieser Stelle über ein Kontaktloch mit zwei Speicherzellen verbunden ist. Nach dem Kontakt 17B wird die Bitleitung BL<1> in der unteren leitenden Schicht bis zum oberen Rand der Fig. 5 geführt.

Am oberen Rand der Fig. 5 wird die zur Bitleitung BL<1> komplementäre Bitleitung bBL<1> in der oberen leitenden Schicht geführt. In dieser oberen leitenden Schicht wird die Bitleitung bBL<1> auf der linken Seite an dem Kontakt 17B, vorbei geführt und trifft dann auf den Kontakt 17A. Durch den Kontakt 17A wird die Bitleitung bBL<1> zu der unteren leitenden Schicht geführt, welche an dieser Stelle über ein Kontaktloch mit zwei Speicherzellen verbunden ist. Nach dem Kontakt 17A wird die Bitleitung bBL<1> in der unteren leitenden Schicht bis zum unteren Rand der Fig. 5 geführt.

Dabei ist es bevorzugt, wenn die Kontakt 17A, 17B und die Kontaktlöcher 15 in der Aufsicht überlappend angeordnet sind. Auf diese weise lassen sich sehr kleine Speicherzellen realisieren.

Fig. 6 zeigt die Umgebung des Kontakts 17A im Schnitt. Die in Fig. 6 gezeigte Situation unterscheidet sich von der in Fig. 1 gezeigten Situation darin, daß in Fig. 6 zwischen der oberen leitfähigen Schicht 16 unter der unteren leitfähigen Schicht 14 ein Kontakt 17A vorgesehen ist. Alle weiteren in Fig. 6 gezeigten Elemente entsprechen den in Fig. 1 gezeigten Elementen und werden daher nicht weiter erläutert.

Um sicher zustellen, daß auch bei dem Vorliegen von Justierungsfehlern bei der Herstellung der Speicheranordnung ein Kontakt zwischen der unteren und der oberen leitenden Schicht sicher zustande kommt, ist die untere leitende Schicht 14 im Bereich des Kontakt 17 breiter ausgelegt. Dies ist auch aus Fig. 5 ersichtlich.

Anstatt die untere leitende Schicht im Bereich des Kontakt 17A selbst breiter auszulegen, kann auch ein zusätzliches Landing Pad 18 vorgesehen sein. Dabei kann das Landing Pad beispielsweise aus dem Material der unteren Elektrode 7 oder aus dem Material der oberen Elektrode 9 gefertigt sein.

Die erfindungsgemäße Speicheranordnung besitzt den Vorteil, daß durch die Anordnung Stapelkondensatoren zwischen der ersten und der zweiten leitfähigen Schicht sowohl die Aspektverhältnisse der Kontaktlöcher 15, welche die ersten leitfähige Schicht 14 mit den Auswahltransistoren 5 verbindet, als auch die Aspektverhältnisse der sogenannten "Plugs" 10, welche die Speicherkondensatoren mit den Auswahltransistoren 5 verbindet, relativ niedrig gehalten werden können. Darüber hinaus können fortgeschrittene Bitleitungskonzepte in sehr kleinen Speicherzellen realisiert werden.

### Bezugszeichenliste

- 1: Siliziumsubstrat
- 2: Diffusionsgebiet
- 3: Gateelektrode
- 4: SiO₂-Schicht
- 5: Auswahltransistor
- 6: SiO₂-Schicht
- 7: untere Elektrode
- 8: Ferro-/Dielektrikum
- 9: obere Elektrode
- 10: Plug
- 12: SiO₂-Schicht
- 14: Aluminiumschicht
- 15: Kontaktloch
- 16: Aluminiumschicht
- 17A: Kontakt
- 17B: Kontakt
- 18: Landing Pad
- 23: Linie
- 24: Linie
- 25: Linie
- 26: Linie
- 27: Linie
- 28: Linie

## Patentansprüche

1. Speicheranordnung mit einer Vielzahl von Speicherzellen, die jeweils wenigstens einen Auswahltransistor (5) und einen Stapelkondensator aufweisen und über Wort- und Bitleitungen ansteuerbar sind,
**dadurch gekennzeichnet, daß**
a) eine erste leitfähige Schicht (14),
b) eine zweite leitfähige Schicht (16), die von der ersten leitfähigen Schicht (14) durch isolierende Schicht (12) getrennt ist, und
c) jeweils für eine vorbestimmte Anzahl der Speicherzellen eine erste Bitleitung (BL<0>, BL<1>, BL<2>) und eine zweite Bitleitung (bBL<0>, bBL<1>, bBL<2>) vorgesehen sind, welche jeweils zum Teil in der ersten leitfähigen Schicht (14) geführt und von dort mit zumindest einem Teil der Speicherzellen verbunden sind und die jeweils zum Teil in der zweiten leitfähigen Schicht (16) geführt sind, und wobei der Teil der ersten Bitleitung (BL<0>, BL<1>, BL<2>) bzw. der zweite Bitleitung (bBL<0>, bBL<1>, bBL<2>), der in der ersten leitfähigen Schicht (14) geführt ist, und der Teil der ersten Bitleitung (BL<0>, BL<1>, BL<2>) bzw. der zweite Bitleitung (bBL<0>, bBL<1>, bBL<2>), der in der zweiten leitfähigen Schicht (16) geführt ist, über zumindest einen ersten Kontakt (17B) bzw. zumindest einen zweiten Kontakt (17A) durch die isolierende Schicht (12) miteinander verbunden sind,
d) beim Auslesen der Speicherzellen die ersten Bitleitungen (BL<0>, BL<1>, BL<2>) und die zweiten Bitleitung (bBL<0>, bBL<1>, bBL<2>) zueinander komplementär sind,
e) die Stapelkondensatoren (7,8,9) der Speicherzellen zwischen der ersten und der zweiten leitfähigen Schicht angeordnet sind, und
f) der erste und/oder zweite Kontakt (17A, 17B) über aktiven Gebiet überlappend mit einem Kontaktloch (15) zu einer Speicherzelle angeordnet sind.

2. Speicheranordnung nach Anspruch 1,
**dadurch gekennzeichnet,**
**daß** die Bitleitungen (BL<0>, BL<1>, BL<2>, bBL<0>, bBL<1>, bBL<2>) mit einem Verstärker (SA) verbunden sind, der die Ladung ausließt, die in einer der Speicherzellen gespeichert ist.

3. Speicheranordnung nach Anspruch 2,
**dadurch gekennzeichnet,**
**daß** der erste und zweite Kontakt (17A, 17B) so angeordnet sind, daß für den Verstärker (SA) die Kapazitäten der ersten und der zweiten Bitleitung im wesentlichen gleich sind.

4. Speicheranordnung nach einem der Ansprüche 1 bis 3,
**dadurch gekennzeichnet,**
**daß** zwischen dem ersten und/oder zweiten Kontakt (17A, 17B) und der ersten leitenden Schicht (14) ein Landing Pad (18) angeordnet ist.

5. Speicheranordnung nach einem der Ansprüche 1 bis 4,
**dadurch gekennzeichnet,**
**daß** im Bereich des ersten und/oder zweiten Kontakts (17A, 17B) die ersten leitende Schicht (14) eine Verbreiterung aufweist.

6. Speicheranordnung nach einem der voherstehenden Ansprüche, **dadurch gekennzeichnet,**
**daß** die Speicherzellen mit einem Winkel zwischen 10° und 60° gegenüber der ersten und/oder der zweiten Bitleitung (BL<0>, BL<1>, BL<2>, bBL<0>, bBL<1>, bBL<2>) ausgerichtet sind.

7. Speicheranordnung nach Anspruch 6,
**dadurch gekennzeichnet,**
**daß** die Speicherzellen mit einem Winkel zwischen 20° und 40° gegenüber der ersten und/oder der zweiten Bitleitung (BL<0>, BL<1>, BL<2>, bBL<0>, bBL<1>, bBL<2>) ausgerichtet sind.

8. Speicheranordnung nach einem der voherstehenden Ansprüche, **dadurch gekennzeichnet,**
**daß** die Speicherzellen mit einer lateralen Ausdehnung von kleiner oder gleich 7F² ausgebildet sind.

## Claims

1. Memory arrangement comprising a multiplicity of memory cells which each have at least one selection transistor (5) and a stacked capacitor and can be driven via word and bit lines,
**characterized in that**
a) a first conductive layer (14),
b) a second conductive layer (16), which is isolated from the first conductive layer (14) by an insulating layer (12), and
c) in each case for a predetermined number of the memory cells a first bit line (BL<0>, BL<1>, BL<2>) and a second bit line (bBL<0>, bBL<1>, bBL<2>) are provided, which are led in each case in part in the first conductive layer (14) and from there are connected to at least one portion of the memory cells and which are led in each case in part in the second conductive layer (16), and that part of the first bit line (BL<0>, BL<1>, BL<2>) and respectively of the second bit line (bBL<0>, bBL<1>, bBL<2>) which is led in the first conductive layer (14) and that part of the first bit line (BL<0>, BL<1>, BL<2>) and respectively of the second bit line (bBL<0>, bBL<1>, bBL<2>) which is led in the second conductive layer (16) being connected to one another via at least one first contact (17B) and respectively at least one second contact (17A) through the insulating layer (12),
d) when reading from the memory cells, the first bit lines (BL<0>, BL<1>, BL<2>) and the second bit lines (bBL<0>, bBL<1>, bBL<2>) are complementary to one another,
e) the stacked capacitors (7, 8, 9) of the memory cells are arranged between the first and second conductive layers, and
f) the first and/or second contact (17A, 17B) are arranged over active zone in a manner overlapping a contact hole (15) to a memory cell.

2. Memory arrangement according to Claim 1,
**characterized**
**in that** the bit lines (BL<0>, BL<1>, BL<2>, bBL<0>, bBL<1>, bBL<2>) are connected to an amplifier (SA) that reads out the charge stored in one of the memory cells.

3. Memory arrangement according to Claim 2,
**characterized**
**in that** the first and second contacts (17A, 17B) are arranged in such a way that the capacitances of the first and second bit lines are essentially identical for the amplifier (SA).

4. Memory arrangement according to one of Claims 1 to 3,
**characterized**
**in that** a landing pad (18) is arranged between the first and/or second contact (17A, 17B) and the first conductive layer (14).

5. Memory arrangement according to one of Claims 1 to 4,
**characterized**
**in that** the first conductive layer (14) has a widening in the region of the first and/or second contact (17A, 17B).

6. Memory arrangement according to one of the preceding claims,
**characterized**
**in that** the memory cells are oriented at an angle of between 10° and 60° with respect to the first and/or the second bit line (BL<0>, BL<1>, BL<2>, bBL<0>, bBL<1>, bBL<2>).

7. Memory arrangement according to Claim 6,
**characterized**
**in that** the memory cells are oriented at an angle of between 20° and 40° with respect to the first and/or the second bit line (BL<0>, BL<1>, BL<2>, bBL<0>, bBL<1>, bBL<2>).

8. Memory arrangement according to one of the preceding claims,
**characterized**
**in that** the memory cells are formed with a lateral extent of less than or equal to 7 F².

## Revendications

1. Dispositif de mémoire ayant une pluralité de cellules de mémoire qui ont, respectivement, au moins un transistor (5) de sélection et un condensateur de stockage et qui peut être commandé par des lignes de mots et des lignes de bits,
**caractérisé en ce que**
a) une première couche (14) conductrice ;
b) une deuxième couche (16) conductrice qui est séparée de la première couche (14) conductrice par une couche (12) isolante ; et
c) il est prévu, respectivement, pour un premier nombre déterminé à l'avance des cellules de mémoire une première ligne (BL < 0 >, BL < 1 >, BL < 2 >) de bits et une deuxième ligne (bBL < 0 >, bBL < 1 >, bBL < 2 >) de bits qui passent, respectivement, en partie dans la première couche (14) conductrice et, de là, sont reliées à au moins une partie des cellules de mémoire et qui passent, respectivement, en partie dans la deuxième couche (16) conductrice, et dans lequel la partie de la première ligne (BL < 0 >, BL < 1 >, BL < 2 >) de bits ou de la deuxième ligne (bBL < 0 >, bBL < 1 >, bBL < 2 >) de bits qui passe dans la première couche (14) conductrice et la partie de la première ligne (BL < 0 >, BL < 1 >, BL < 2 >) de bits ou de la deuxième ligne (bBL < 0 >, bBL < 1 >, bBL < 2 >) de bits qui passe dans la deuxième couche (16) conductrice sont reliées par au moins un premier contact (17B) ou au moins un deuxième contact (17A) entre elles à travers la couche (12) isolante ;
d) lors de la lecture des cellules de mémoire les premières lignes (BL < 0 >, BL < 1 >, BL < 2 >) de bits et les deuxièmes lignes (bBL < 0 >, bBL < 1 >, bBL < 2 >) de bits sont complémentaires les unes des autres ;
e) les condensateurs (7, 8, 9) de stockage des cellules de mémoire sont disposés entre la première et la deuxième couche conductrice ; et
f) le premier et/ou le deuxième contact (17A, 17B) sont disposés par une zone active à chevauchement avec un trou (15) de contact allant à une cellule de mémoire.

2. Dispositif de mémoire suivant la revendication 1,
**caractérisé**
**en ce que** les lignes (BL < 0 >, BL < 1 >, BL < 2 >, bBL < 0 >, bBL < 1 >, bBL < 2 >) de bits sont reliées à un amplificateur (SA) qui lit la charge qui est mémorisée dans l'une des cellules de mémoire.

3. Dispositif de mémoire suivant la revendication 2,
**caractérisé en ce que**
le premier et le deuxième contact (17A, 17B) sont disposés de façon à ce que, pour l'amplificateur (SA), les capacités de la première et de la deuxième ligne de bits sont sensiblement égales.

4. Dispositif de mémoire suivant l'une des revendications 1 à 3,
**caractérisé en ce que**
il est disposé un Landing Pad (18) entre le premier et le deuxième contact (17A, 17B) et la première couche (14) conductrice.

5. Dispositif de mémoire suivant l'une des revendications 1 à 4,
**caractérisé en ce que**,
dans la zone du premier et/ou du deuxième contact (17A, 17B), la première couche (14) conductrice présente un élargissement.

6. Dispositif de mémoire suivant l'une des revendications précédentes,
**caractérisé en ce que**
les cellules de mémoire font un angle compris entre 10° et 60° avec la première et/ou la deuxième ligne (BL< 0 >, BL < 1 >, BL < 2 >, bBL < 0 >, bBL < 1 >, bBL < 2 >) de bits.

7. Dispositif de mémoire suivant la revendication 6,
**caractérisé en ce que**
les cellules de mémoire font un angle compris entre 20° et 40° avec la première et/ou la deuxième ligne (BL < 0 >, BL < 1 >, BL < 2 >, bBL < 0 >, bBL < 1 >, bBL < 2 >) de bits.

8. Dispositif de mémoire suivant l'une des revendications précédentes,
**caractérisé en ce que**
les cellules de mémoire sont constituées en ayant une étendue latérale inférieure ou égale à 7F².
